# EUROPÄISCHE PATENTANMELDUNG

(11) **EP 0 584 722 A1**
(43) Veröffentlichungstag der Anmeldung: **02.03.1994**
(21) Anmeldenummer: 93113269.0
(22) Anmeldetag: 19.08.1993
(51) Int. Cl.: H01L 31/18, H01L 31/20

(54) **Verfahren zur Herstellung von mit Fotovoltaikmodulen versehenen Bauelementen**

(30) Priorität: 22.08.1992 DE 4227966
(71) Anmelder: HOESCH SIEGERLANDWERKE GmbH, D-57078 Siegen-Geisweid (DE)
(72) Erfinder: Kowallik, Josef, D-57528 Freudenberg (DE)

(57) **Zusammenfassung**

Um ein Verfahren zur Herstellung von mit Fotovoltaikmodulen versehenen flächigen Bauelementen, wobei die Fotovoltaikmodule über eine Isolierschicht auf eine Trägerschicht appliziert und mit einer Schutzschicht abgedeckt werden, zu schaffen, das es erlaubt, derartige Bauelemente rationell und kostengünstig herstellen zu können, werden die Fotovoltaikmodule und die Isolierschicht kontinuierlich auf eine ebenfalls kontinuierlich zugeführte Trägerschichtbahn appliziert, wobei die Schutzschicht ebenfalls vorzugsweise kontinuierlich aufgebracht wird, und die einzelnen Bauelemente aus der mit Isolierschicht, Fotovoltaikmodulen und Schutzschicht versehenen Trägerschichtbahn herausgetrennt werden.

## Beschreibung

Die Erfindung betrifft ein Verfahren gemäß dem Oberbegriff des Anspruches 1.

Aus der Praxis sind derartige Bauelemente bekannt, die auf die Art hergestellt werden, indem auf eine in ihren Abmessungen begrenzte Trägerschicht eine entsprechende große Isolierschicht aufgebracht wird, auf die danach die Fotovoltaikmodule und auf diese die Schutzschicht appliziert werden.

Diese bekannte Herstellungsart, jedes Bauelement einzeln herzustellen, ist aber sehr aufwendig und daher wirtschaftlich nicht vertretbar.

Von daher liegt der Erfindung die Aufgabe zugrunde, ein Verfahren der eingangs genannten Art zu schaffen, das es erlaubt, derartige Bauelemente rationell und kostengünstig herstellen zu können.

Diese Aufgabe wird durch die im kennzeichnenden Teil des Anspruchs 1 angegebenen Merkmale gelöst.

Vorteilhafte und zweckmäßige Ausführungen des erfindungsgemäßen Verfahrens sind in den Ansprüchen 2 bis 8 angegeben.

Die mit dem erfindungsgemäßen verfahren erzielten Vorteile sind insbesondere durch die kontinuierliche Fertigungsweise darin zu sehen, daß auch großflächige multifunktionale Bauelemente ohne Längenbeschränkung in großer Stückzahl z. B. für den Einsatzbereich Energiegewinnung an Gebäudedächern und Fassaden rationell und auf einfache Weise wirtschaftlich hergestellt werden können.

Anhand der schematischen Zeichnung wird das erfindungsgemäße Verfahren im folgenden näher erläutert.

Es zeigt
Fig. 1 eine aufgerollte Trägerschicht,
Fig. 2 eine andere aufgerollte Trägerschicht,
Fig. 3 eine Fertigungsstrecke,
Fig. 4 eine andere Fertigungsstrecke,
Fig. 5 eine Projektierungsskizze für eine Fertigungsstrecke.

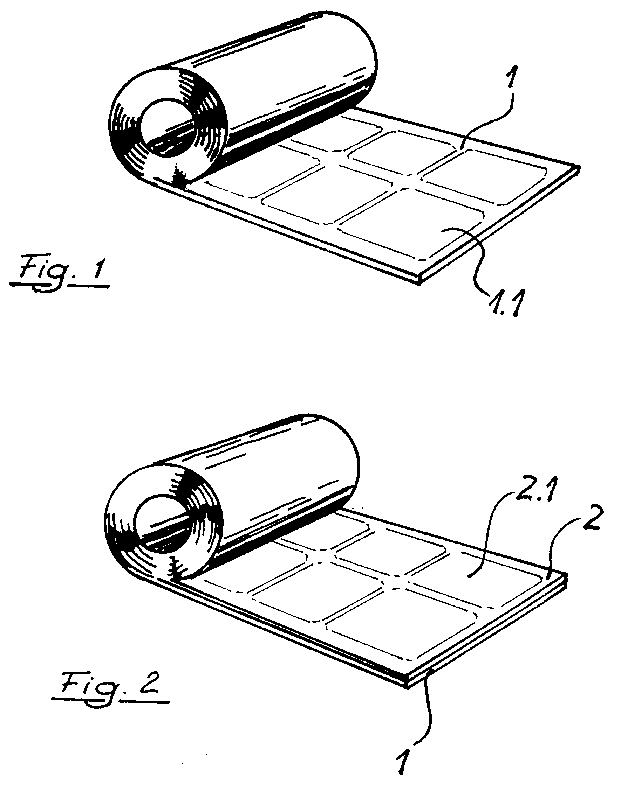

Wie aus der Fig. 1 hervorgeht, ist auf eine Trägerschicht 1 direkt ein Schichtenaufbau 1.1, bestehend aus Isolierschicht, Fotovoltaikmodulen und Schutzschicht appliziert, wogegen die Fig. 2 eine Trägerschicht 1 darstellt, auf die eine Folie 2 mit dem Folienschichtenaufbau 2.1 mit Isolierschicht, Fotovoltaikmodulen und Schutzschicht aufkaschiert ist, wobei es auch möglich ist, die Isolierschicht vor der Kaschierung auf die Trägerschicht 1 aufzutragen.

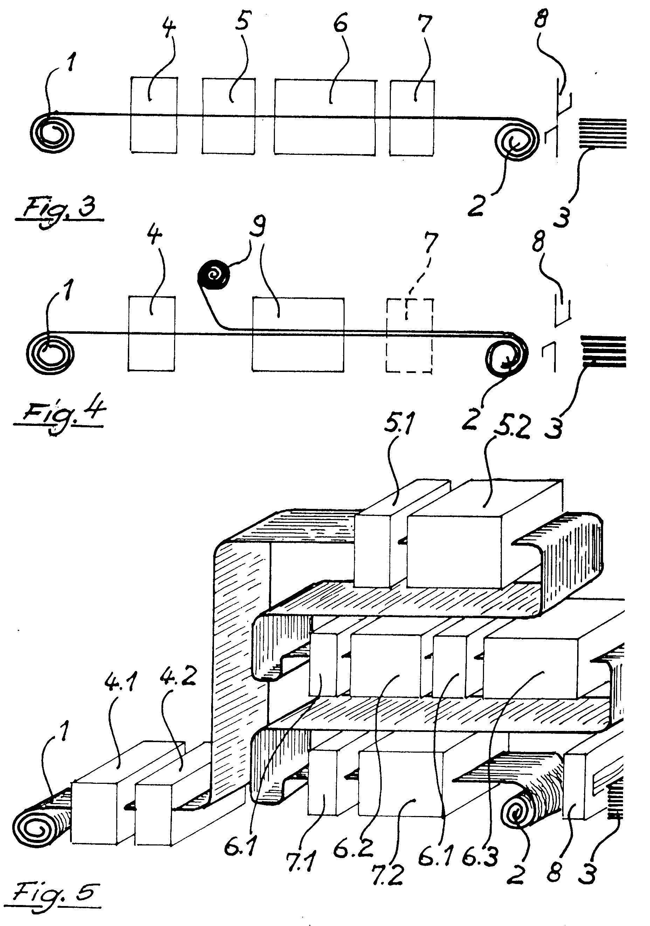

Die Fig. 3 zeigt, wie die Trägerschicht 1 von einem Abhaspel kommend kontinuierlich nacheinander einer Substratvorbehandlung 4, der Applikation der Isolierschicht 5, der Fotovoltaikmodule 6 und der Schutzschicht 7 zugeführt wird, wonach das Fertigmaterial zunächst entweder zu einem Coil 2 aufgerollt, wobei die einzelnen Bauelemente in einer nicht dargestellten weiteren Fertigungsstation von dem dann zunächst abzuhaspelnden Fertigmaterial abgelängt werden, oder direkt mittels einer Schere 8 zu abgelängtem Tafelmaterial 3 verarbeitet wird.

Die Fig. 4 stellt die Verfahrensweise der Folienkaschierung dar. Es wird danach die vom Abhaspel kommende Trägerschicht 1 wiederum kontinuierlich zunächst der Substratvorbehandlung 4 zugeführt, wonach dann die Folienapplikation 9 kontinuierlich vorgenommen wird, wobei es möglich ist, eine Folie mit Isolierschicht, Fotovoltaikmodulen und Schutzschicht insgesamt aufzukaschieren oder auch nur zunächst eine Folie mit Isolierschicht und Fotovoltaikmodulen und die Schutzschicht danach in der Station 7.

Anschließend ist es wie bei der Verfahrensweise nach Fig. 3 möglich, das Fertigmaterial zunächst zu einem Coil 2 aufzurollen oder auch direkt mittels Schere 8 zu Tafelmaterial 3 abzulängen.

Die Fig. 5 stellt eine Projektierungsskizze dar, wonach die Trägerschicht 1 nach dem Abhaspeln einer chemischen 4.1 und mechanischen Vorbehandlung 4.2 zunächst kontinuierlich zugeführt wird. Auf die so vorbereitete Trägerschicht 1 wird die Isolierschicht in der Station 5.1 aufgebracht und über eine Reaktionsstrecke 5.2 (z. B. Ofen) der Fotovoltaikstruktuierung 6.1 zugeführt, wobei die Fotovoltaikstruktuierung 6.1 fototechnisch und/oder nach einem thermischen Umdruckverfahren geschehen kann. 6.2 bezeichnet die Fotovoltaik-p-i-n-Beschichtung, die aus einer Aufdampfstrecke oder chemischen Abscheidung oder einem anderen Beschichtungsverfahren bestehen kann.

Nach der Reaktionsstrecke 6.3 (z. B. Ofen) wird auf die mit Isolierschicht und Fotovoltaikmodulen versehene Trägerschicht 1 in der Station 7.1 die Schutzschicht aufgebracht, die mittels Naßabscheidung, Folienbeschichtung oder chem. Abscheidung appliziert werden kann.

Nach der Reaktionsstrecke 7.2 (z. B. Ofen) wird dann das Fertigungsmaterial entweder zunächst zu einem Coil 2 aufgerollt, und später abgelängt, oder direkt mittels der Schere 8 zu Tafelmaterial 3, das im wesentlichen die Bauelemente bereits darstellt, abgelängt, wie auch bereits oben beschrieben.

## Patentansprüche

1. Verfahren zur Herstellung von mit Fotovoltaikmodulen versehenen flächigen Bauelementen, wobei die Fotovoltaikmodule über eine Isolierschicht auf eine Trägerschicht appliziert und mit einer Schutzschicht abgedeckt werden, dadurch gekennzeichnet, daß die Fotovoltaikmodule und die Isolierschicht kontinuierlich auf eine ebenfalls kontinuierlich zugeführte Trägerschichtbahn appliziert werden, wobei die Schutzschicht ebenfalls vorzugsweise kontinuierlich aufgebracht wird, und die einzelnen Bauelemente aus der mit Isolierschicht, Fotovoltaikmodulen und Schutzschicht versehenen Trägerschichtbahn herausgetrennt werden.

2. Verfahren nach Anspruch 1, dadurch gekennzeichnet, daß die Fotovoltaikmodule mit der Isolierschicht zusammen als vorgefertigte Folie auf die Trägerschichtbahn kaschiert werden und die Schutzschicht anschließend aufgebracht werden.

3. Verfahren nach Anspruch 1, dadurch gekennzeichnet, daß die Fotovoltaikmodule, Isolierschicht und Schutzschicht zusammen als vorgefertigte Folie auf die Trägerschichtbahn kaschiert werden.

4. Verfahren nach Anspruch 1, dadurch gekennzeichnet, daß die Fotovoltaikmodule auf die vorher mit der Isolierschicht versehene Trägerschichtbahn appliziert werden.

5. Verfahren nach Anspruch 4, dadurch gekennzeichnet, daß die Fotovoltaikmodule auf die bereits mit der Isolierschicht versehene Trägerschichtbahn aufgedampft werden.

6. Verfahren nach einem oder mehreren der Ansprüche 1 bis 4, dadurch gekennzeichnet, daß die mit den Fotovoltaikmodulen, Isolierschicht und Schutzschicht versehene Trägerschichtbahn zunächst zu einem Coil aufgehaspelt wird und in einer zweiten Stufe nach dem Abhaspeln die Bauelemente herausgetrennt werden.

7. Verfahren nach einem oder mehreren der Ansprüche 1 bis 6, dadurch gekennzeichnet, daß die Trägerschichtbahn aus einem von einem Haspel abgezogenen Metallband besteht.

8. Verfahren nach Anspruch 7, dadurch gekennzeichnet, daß die Trägerschichtbahn ein Stahlblechband ist.
